# EUROPÄISCHE PATENTSCHRIFT

(11) **EP 3 143 847 B1**
(45) Veröffentlichungstag und Bekanntmachung des Hinweises auf die Patenterteilung: **12.07.2023**
(21) Anmeldenummer: 15726023.3
(22) Anmeldetag: 13.05.2015
(51) Int. Cl.: H05K 1/02, H05K 3/40, H05K 1/11, H05K 1/18, H05K 3/12

(54) **VERFAHREN ZUM HERSTELLEN EINES LEITERZUGS MIT VERBREITERUNGSFREIEM ÜBERGANG ZWISCHEN LEITERBAHN UND KONTAKTSTRUKTUR**
METHOD FOR MANUFACTURING A CONDUCTOR TRACK WITH ENLARGEMENT-FREE TRANSITION BETWEEN CONDUCTOR PATH AND CONTACT STRUCTURE
PROCEDE DE FABRIQUER D'UN CHEMIN CONDUCTEUR PRÉSENTANT UNE TRANSITION SANS ÉLARGISSEMENT ENTRE UNE PISTE CONDUCTRICE ET UNE STRUCTURE DE CONTACT

(30) Priorität: 14.05.2014 AT 503392014
(43) Veröffentlichungstag der Anmeldung: 22.03.2017
(73) Patentinhaber: AT & S Austria Technologie & Systemtechnik Aktiengesellschaft, 8700 Leoben (AT)
(72) Erfinder: STAHR, Johannes, A-8605 St. Lorenzen im Mürztal (AT); SCHRITTWIESER, Wolfgang, A-8605 Kapfenberg (AT); MORIANZ, Mike, A-8045 Graz (AT); VOCKENBERGER, Christian, A-8700 Leoben (AT); LEITGEB, Markus, A-8793 Trofaiach (AT)
(74) Vertreter: Dilg, Haeusler, Schindelmann Patentanwaltsgesellschaft mbH
(86) Internationale Anmeldenummer: PCT/EP2015/060681
(87) Internationale Veröffentlichungsnummer: WO 2015/173347

(56) Entgegenhaltungen:
- DE-A1- 4 343 843
- US-A1- 2003 215 566
- US-A1- 2005 196 898
- US-A1- 2007 222 549
- US-A1- 2013 009 322
- US-A1- 2013 186 679
- US-A1- 2013 277 099

## Beschreibung

Die Erfindung betrifft ein Verfahren zum Herstellen einer elektronischen Vorrichtung.

Es sind verschiedene Verfahren zur Einbettung von Komponenten (passiven und aktiven) innerhalb einer Leiterplatte bekannt. Diese Technik wird als Embedding bezeichnet. Durch die zunehmende Miniaturisierung werden die Verbindungen zwischen den Komponenten immer kleiner und feiner. Durch die Reduktion der Länge dieser Verbindungswege wird auch der Verlust und in Summe der Energieverbrauch ebenfalls immer kleiner. Durch die kurzen Verbindungswege und die damit resultierenden kleineren Distanzen werden die kapazitiven und induktiven Einflüsse der Leiterplatte ebenfalls kleiner, was immer höhere Grenzfrequenzen der eingebetteten Komponenten erlaubt.

Herkömmlich wird in der Leiterplattentechnologie ein Übergang einer Leiterbahn zu einem Via üblicherweise mit einem Pad realisiert, das heißt mit einem lokal gegenüber Leiterbahn und Via verbreitertem elektrisch leitfähigen Element. Solch ein Pad wird üblicherweise zum Abfangen von Produktionstoleranzen zwingend vorgegeben.

US 2013/0277099 A1 offenbart eine Leiterstruktur mit einem integrierten Via Element. Zwischen einer oberen Leiterbahn und einer unteren Leiterbahn werden sogenannte Via Segmente angebracht, welche ebenfalls leitend sind. Zwischen den Via Segmenten befinden sich weiterhin Beabstandungen. Der Gegenstand wird in eine gedruckte Leiterplatte implementiert und weist die Leiterbahnen auf, welche jeweils mittels einem Via Segment verbunden sind.

US 2013/0186679 A1 offenbart eine mehrschichtige Verdrahtungsstruktur. Die Struktur umfasst ein Substrat mit einem Verbindungsloch, so dass eine Oberfläche und eine andere Oberfläche des Substrats verbunden werden können. An dem Substrat sind Elektrodenverdrahtungen angebracht, wobei erste Verdrahtungen auf der einen Oberfläche des Substrats ausgebildet sind und zweite Verdrahtungen auf der anderen Oberfläche des Substrats ausgebildet sind. Weiterhin sind Verbindungsleitungen auf einer Innenfläche des Verbindungslochs ausgebildet.

US 2003/0215566 A1 offenbart eine feine Strukturierung und einen feinen Fest-Via Prozess für Mehrschicht-Substrate. Gemäß der Zusammenfassung wird eine dielektrische Schicht auf mindestens einer Oberfläche eines Substrats angeordnet. Via und Schaltkreis werden auf der dielektrischen Schicht mittels Laser-Ablation definiert. Die Oberfläche der dielektrischen Schicht wird weiterhin mit Sub-Mikro Leitpaste bedruckt.

US 2013/0009322 A1 offenbart ein Substrat-durchgängiges Via (TSV), welches einen streifenförmigen und lochdurchgängigen Signalleiter aufweist. Ein Via ist in einem Substrat angeordnet, wobei an einer Seitenwand des Vias ein vertikal angeordneter elektrisch leitender Metallstreifen verläuft. Dieser vertikale Metallstreifen verläuft zwischen einem ersten horizontalen Metallstreifen, welcher entlang der Oberfläche des Substrats verläuft, und einem zweiten horizontalen Metallstreifen, welcher entlang der Unterseite des Substrats verläuft.

Es ist eine Aufgabe der vorliegenden Erfindung, eine mit geringem Aufwand herstellbare elektronische Vorrichtung bereitzustellen, die selbst hochfrequente Signale verlustarm handhaben kann.

Diese Aufgabe wird durch die Gegenstände mit den Merkmalen gemäß den unabhängigen Patentansprüchen gelöst. Weitere Ausführungsbeispiele sind in den abhängigen Ansprüchen gezeigt.

Gemäß einem Ausführungsbeispiel der vorliegenden Erfindung ist ein Verfahren zum Herstellen einer elektronischen Vorrichtung bereitgestellt, das Verfahren aufweisend:
Bereitstellen einer elektrisch isolierenden Trägerstruktur, wobei die Trägerstruktur zumindest eines aus der Gruppe aufweist, welche besteht aus: einer harzhaltigen Platte, einem Glassubstrat, einem organischen Substrat; Bilden einer elektrisch leitfähigen Leiterbahn an einer Oberfläche der Trägerstruktur;
Bilden einer elektrisch leitfähigen Kontaktstruktur, die sich ausgehend von der Oberfläche in die Trägerstruktur hinein erstreckt und unter Bildung eines gemeinsamen Leiterzugs an einer Verbindungsstelle an die Leiterbahn elektrisch angeschlossen wird.

In der Trägerstruktur wird eine sich in diese hinein erstreckende Kontaktöffnung gebildet, die nachfolgend mit elektrisch leitfähigem Material gefüllt wird, um dadurch die Kontaktstruktur zu bilden, so dass die Kontaktstruktur als mit dem elektrisch leitfähigen Material gefülltes Sackloch oder Durchgangsloch in der Trägerstruktur ausgebildet ist.

An der Verbindungsstelle werden die Leiterbahn und die Kontaktstruktur ineinander verbreiterungsfrei übergehend ausgebildet.

Die Leiterbahn und die Kontaktstruktur weisen zumindest im Bereich der Verbindungsstelle einen konstanten Querschnitt auf und eine Prozedur des Definierens einer Gestalt der Leiterbahn und eine Prozedur des Definierens einer Gestalt der Kontaktstruktur schließen sich unterbrechungsfrei aneinander an oder werden simultan miteinander durchgeführt.

Gemäß einem weiteren Ausführungsbeispiel der vorliegenden Erfindung wird eine Vorrichtung, die nach dem oben beschriebenen Verfahren hergestellt ist, zum Transportieren (insbesondere zum Einkoppeln) eines Hochfrequenzsignals, insbesondere mit einer Frequenz von mindestens ungefähr 10 GHz, zum (insbesondere oberwellenarmen, weiter insbesondere oberwellenfreien) Propagieren durch den Leiterzug aus der Leiterbahn und der Kontaktstruktur verwendet, insbesondere im Wege einer hohlleiterbasierenden Wellenausbreitung.

Gemäß einem weiteren Ausführungsbeispiel der vorliegenden Erfindung wird eine Vorrichtung, die nach dem oben beschriebenen Verfahren hergestellt ist, zum Impedanzanpassen des Leiterzugs verwendet.

Gemäß einem weiteren Ausführungsbeispiel der vorliegenden Erfindung wird eine Vorrichtung, die nach dem oben beschriebenen Verfahren hergestellt ist, zum wärmebarrierefreien Übertragen von thermischer Energie zwischen der Leiterbahn und der Kontaktstruktur über die Verbindungsstelle verwendet (insbesondere zur Maximierung der Wärmeübertragung, zum Beispiel mittels einer Sinteranbindung).

Gemäß einem weiteren Ausführungsbeispiel der vorliegenden Erfindung wird eine Vorrichtung, die nach dem oben beschriebenen Verfahren hergestellt ist, zum verlustarmen Übertragen von elektrischem Strom zwischen der Leiterbahn und der Kontaktstruktur über die Verbindungsstelle verwendet (insbesondere zur Maximierung der Stromdurchgangsfähigkeit durch Minimierung der elektrischen Übergangswiderstände).

Gemäß einem Ausführungsbeispiel der vorliegenden Erfindung ist eine elektronische Vorrichtung, die nach dem oben beschriebenen Verfahren hergestellt ist, geschaffen, bei der eine direkte elektrisch leitfähige Verbindung zwischen einer Leiterbahn auf einer elektrisch isolierenden Trägerstruktur und einer Kontaktstruktur im Inneren der elektrisch isolierenden Trägerstruktur ohne dazwischen angeordneter Verbreiterungsstruktur (zum Beispiel in Form eines erfindungsgemäß weggelassenen verbreiternden Pads) ermöglicht ist. Eine solche elektronische Vorrichtung ist vorteilhaft mit geringem Aufwand herstellbar, da keine separate Prozedur zum definierten Ausbilden einer Verbreiterungsstruktur nötig ist. Darüber hinaus ist eine solche elektronische Vorrichtung im Betrieb energiesparend verwendbar, da insbesondere beim Propagieren hochfrequenter Signale durch den aus Leiterbahn und Kontaktstruktur gebildeten Leiterzug infolge des homogenen elektrischen leitfähigen Übergangs und der wenigen Kontaktwiderstände Verluste stark unterdrückt sind. Die Verbreiterungsfreiheit des elektrischen Übergangs hemmt auch das Ausbilden parasitärer Moden und unterdrückt andere parasitäre Effekte, die durch eine Inhomogenität an der Verbindung zwischen Leiterbahnen und Kontaktstruktur ausgelöst oder gefördert werden können. Ferner erlaubt das Weglassen einer Verbreiterung zwischen Verbindungsstelle und Leiterbahnen eine fortgesetzte Miniaturisierung. Somit kann, zum Beispiel wenn die elektronische Vorrichtung als Leiterplatte ausgebildet ist, eine höhere Integrationsdichte von Komponenten und elektrischen Kopplungen erreicht werden. Insbesondere mit der zu immer höheren Frequenzen voranschreitenden Hochfrequenztechnik kann mit einer erfindungsgemäßen Vorrichtung eine verbesserte Verarbeitbarkeit von Hochfrequenzsignalen ermöglicht werden, da diese bei einem verbreiterungsfreien Übergang zwischen Leiterbahn und Kontaktstruktur sehr verlustarm, aufgrund des einsetzenden Skineffekts anschaulich ähnlich wie in einem Hohlleiter, übertragen werden können.

Im Weiteren werden zusätzliche exemplarische Ausführungsbeispiele des Verfahrens beschrieben.

Gemäß einem exemplarischen Ausführungsbeispiel kann die Verbindungsstelle padfrei ausgebildet sein. Indem zwischen Leiterbahnen und Kontaktstrukturen keine Pads vorgesehen werden, ist nicht nur eine vereinfachte Herstellbarkeit durch Einsparung eines Prozessschritts, sondern auch eine höhere Homogenität hinsichtlich der eingesetzten Materialien und Strukturen erreichbar, und die Anzahl von Materialübergängen ist reduziert.

Die Leiterbahn und die Kontaktstruktur weisen zumindest im Bereich der Verbindungsstelle, vorzugsweise entlang der gesamten Erstreckung der Leiterbahn und der Kontaktstruktur, einen konstanten Querschnitt (insbesondere eine konstante Querschnittsfläche und/oder eine konstante Querschnittsform) auf. Propagieren hochfrequente Signale durch die Leiterbahn und nachfolgend die Kontaktstruktur (oder in umgekehrter Richtung), so erfahren diese an der Verbindungsstelle und vorzugsweise entlang ihres gesamten Wegs durch den Leiterzug keine Störung, wie sie an Unstetigkeiten auftreten können, und welche die ungehemmte Ausbreitung von Hochfrequenzsignalen behindern würden.

Gemäß einem exemplarischen Ausführungsbeispiel können zumindest im Bereich der Verbindungsstelle die Leiterbahn und die Kontaktstruktur aus einem homogenen Material gebildet sein und/oder nahtfrei ineinander übergehen. Das Entstehen einer Verbindungsnaht infolge von zwei unterschiedlichen Prozeduren zum Abscheiden von elektrisch leitfähigen Materialien zum Ausbilden von Leiterbahn und Kontaktstruktur kann gemäß dem beschriebenen Ausführungsbeispiel vermieden werden, wenn Leiterbahn und Kontaktstruktur in einem gemeinsamen Verfahren (zum Beispiel mittels gemeinsamen, simultanen Abschneidens von elektrisch leitfähigem Material in eine oberflächliche Nut und ein mit der Nut zusammenhängendes Tiefloch in der elektrisch isolierenden Trägerstruktur) hergestellt werden. Die resultierende nahtfreie Verbindung ist weniger störanfällig für übertragene elektrische Signale und erlaubt daher den Betrieb der elektronischen Vorrichtung mit geringerem Energieverbrauch.

Gemäß einem exemplarischen Ausführungsbeispiel kann die Kontaktstruktur, vorzugsweise auch die Leiterbahn, einen rechteckförmigen Querschnitt aufweisen. Mit einem solchen rechteckförmigen Querschnitt kann, wenn aufgrund der verwendeten Frequenzen übermittelter Signale der Skineffekt zu einem Propagieren der Signale im Wesentlichen nur entlang einer äußeren Hülle des Leiterzugs führt, eine effiziente Wellenausbreitung erfolgen, was zu einer besonders starken Verringerung der Verlustleistung führt. Anschaulich kann die Ausbreitung der elektrischen Hochfrequenzsignale in dem Leiterzug dann ähnlich wie die Ausbreitung von elektromagnetischen Wellen in einem Hohlraum bzw. einem Hohlraumresonator erfolgen. Die Erfüllung von entsprechenden Bedingungen hinsichtlich einer effizienten Wellenausbreitung (zum Beispiel einer Resonanzbedingung) kann durch eine entsprechende Vorgabe eines Länge-zu-Breite-Verhältnisses des rechteckförmigen Leiterzugs erfolgen (zum Beispiel Verhältnis 2:3). Entsprechend können die Dimensionen des Leiterzugs auch auf eine von einer Treiberschaltung vorgebbare Frequenz der propagierenden Signale angepasst werden.

Alternativ kann die Kontaktstruktur, vorzugsweise auch die Leiterbahn, einen abgerundet rechteckförmigen oder einen runden bzw. ovalen Querschnitt aufweisen. Es sind auch andere polygonale Formen möglich, wie zum Beispiel eine Oktaederform (gegebenenfalls mit abgerundeten Ecken).

Die Kontaktstruktur erstreckt sich im Wesentlichen senkrecht zu einer Erstreckung der Leiterbahn in die Trägerstruktur hinein und ist als Via ausgebildet. Die Kontaktstruktur ist somit als mit einem elektrisch leitfähigen Material gefülltes Sackloch oder Durchgangsloch in der Trägerstruktur ausgebildet. Als Via kann eine Durchsteigeverbindung zwischen unterschiedlichen (insbesondere elektrisch isolierenden) Ebenen der elektronischen Vorrichtung verstanden werden, insbesondere vollständig durchkontaktierend zwischen zwei gegenüberliegenden Hauptoberflächen der Trägerstruktur. Mikrovias mit einem Durchmesser von unter 150 µm bis 200 µm sind möglich.

Gemäß einem exemplarischen Ausführungsbeispiel ist die Trägerstruktur aus einer Gruppe ausgewählt, die besteht aus einer harzhaltigen Platte (insbesondere einer Harz-Glasfaser-Platte), einem Glassubstrat und einem organischen Substrat. Gemäß einer Ausgestaltung der elektronischen Vorrichtung als gedruckte Leiterplatte (Printed Circuit Board, PCB) kann die Trägerstruktur zum Beispiel eine Mischung aus einem Epoxidharz und Glasfasern (zum Beispiel Prepreg) aufweisen, insbesondere FR4. Auch ist eine Mischung aus einem Epoxidharz und Papierpartikeln möglich (zum Beispiel FR1). Gemäß einer anderen Ausgestaltung kann ein Substrat aus Glas oder einer Kohlenstoffverbindung verwendet werden, um darauf und darin einen oder mehrere Leiterzüge mit verbreiterungsfreiem Übergang zwischen Leiterbahn und Kontaktstruktur auszubilden.

Gemäß einem exemplarischen Ausführungsbeispiel können die Leiterbahn und die Kontaktstruktur Kupfer (insbesondere mittels eines galvanischen Verfahrens gebildetes Kupfer) aufweisen oder daraus bestehen. Alternativ oder ergänzend können andere Metalle verwendet werden, zum Beispiel Silber, Aluminium oder Nickel. Es ist auch möglich, hierfür ein elektrisch leitfähiges Polymer (insbesondere Smart Polymers) einzusetzen.

Gemäß einem exemplarischen Ausführungsbeispiel kann die Vorrichtung eine elektronische Komponente (als embedded-Komponente) aufweisen, die in der Trägerstruktur eingebettet ist und mit der Kontaktstruktur und/oder der Leiterbahn elektrisch leitfähig gekoppelt ist. Die mindestens eine elektronische Komponente kann eine aktive elektronische Komponente und/oder eine passive elektronische Komponente aufweisen. Zum Beispiel ist es (insbesondere im Rahmen einer hohlwellenartigen Signalführung) möglich, als elektronische Komponente ein Hochfrequenzbauteil (zum Beispiel ein Mobilfunk-Chip, ein Transistor-Chip oder ein Antennenmodul) in der elektrisch isolierenden Trägerstruktur zu implementieren. Im Rahmen der Impedanzanpassung kann als elektronische Komponente insbesondere ein Filter, ein Speicher (zum Beispiel ein DRAM) oder ein Sensor implementiert werden. Im Rahmen eines ungestörten Wärmetransports kann als elektronische Komponente insbesondere ein ohmscher Widerstand, ein Sensor, ein MOSFET, ein IGBT, eine Leistungsdiode, ein Thyristor oder ein Thermistor implementiert werden.

Gemäß einem exemplarischen Ausführungsbeispiel können an einer anderen Verbindungsstelle der Vorrichtung ein elektrischer Kontakt der elektronischen Komponente einerseits und die Kontaktstruktur oder die Leiterbahn andererseits verbreiterungsfrei ineinander übergehen. Somit kann eine verbreiterungsfreie (insbesondere padfreie) elektrische Kopplung nicht nur zwischen Leiterbahn und Kontaktstruktur, sondern auch zwischen Kontaktstruktur und elektronischer Komponente erfolgen, was die Energieeffizienz der elektronischen Vorrichtung weiter verbessert. Auch an der elektrischen und mechanischen Schnittstelle zwischen Kontaktstruktur und elektronischer Komponente kann somit die Übertragung eines Hochfrequenzsignals barrierefrei bzw. stetig erfolgen.

Gemäß einem exemplarischen Ausführungsbeispiel kann die Vorrichtung eine andere Leiterbahn auf und/oder in der Trägerstruktur, insbesondere an einer zu der die Leiterbahn aufweisenden Oberfläche gegenüberliegenden anderen Oberfläche der Trägerstruktur, aufweisen, wobei an einer weiteren Verbindungsstelle die andere Leiterbahn und die Kontaktstruktur verbreiterungsfrei ineinander übergehen. Auch die elektrisch leitfähige Verbindung zwischen Leiterbahnen an beiden gegenüberliegenden Hauptoberflächen der Vorrichtung (zum Beispiel einer gedruckten Leiterplatte) mittels einer orthogonal hierzu verlaufenden Kontaktstruktur kann somit durch die Trägerstruktur hindurch erfolgen und an beiden gegenüberliegenden Hauptoberflächen verbreiterungsfrei erfolgen.

Gemäß einem Ausführungsbeispiel kann die Verbindungsstelle zwischen der Leiterbahn und der Kontaktstruktur derart ausgebildet sein, dass ein in den Leiterzug eingekoppeltes elektrisches Hochfrequenzsignal, insbesondere reflexionsfrei, durch die Verbindungsstelle propagieren kann. Insbesondere kann die Geometrie der Verbindung zwischen Leiterbahn und Kontaktstruktur so ausgebildet sein, dass ein stetiger und störungsfreier Übergang des Signals zwischen Leiterbahn und Kontaktstruktur ermöglicht ist. Anders ausgedrückt ist bei einer geeigneten Konfiguration von Leiterbahn und Kontaktstruktur, besondere in deren Grenzbereich, ein unerwünschtes Reflektieren von nennenswerten Teilen des elektrischen Hochfrequenzsignals an der Verbindungsstelle vermeidbar und somit eine dämpfungsfreie oder zumindest dämpfungsarme Übermittlung des elektrischen Hochfrequenzsignals möglich.

Gemäß einem exemplarischen Ausführungsbeispiel kann die Vorrichtung eine Treibereinrichtung (zum Beispiel einen Treiberschaltkreis oder eine Treiberkomponente) aufweisen, die zum Generieren und Einkoppeln eines Hochfrequenzsignals in den Leiterzug ausgebildet ist, insbesondere zum Einkoppeln eines Hochfrequenzsignals in einem Frequenzbereich von mindestens ungefähr 10 GHz, insbesondere mindestens ungefähr 5 THz. Die Treibereinrichtung kann zum Beispiel als elektronische Komponente ausgebildet sein und zum Erzeugen eines Hochfrequenzsignals eingerichtet sein, das in den Leiterzug eingekoppelt wird. Dank des verbreiterungsfreien Übergangs zwischen Leiterbahn und Kontaktstruktur kann das hochfrequente Signal, insbesondere resonant, durch den gesamten Leiterzug propagieren. Gemäß einem exemplarischen Ausführungsbeispiel kann eine Flankensteilheit des Hochfrequenzsignals größer als ungefähr 200 V pro ungefähr 50 ps, d.h. größer als 40 V/ps sein. Bei solchen Signalen mit hoher Flankensteilheit wirkt sich der verbreiterungsfreie Übergang besonders vorteilhaft aus.

Das gemäß exemplarischen Ausführungsbeispielen einzukoppelnde Hochfrequenzsignal kann aber auch niedrigere Frequenzen von zum Beispiel ungefähr 100 kHz aufweisen. Insbesondere kann ein solches Hochfrequenzsignal eine Frequenz von mindestens 10 kHz aufweisen, weiter insbesondere zwischen 10 kHz und 1 MHz. Zum Beispiel ist es mit dem verbreiterungsfreien Übergang möglich, ein Rechtecksignal mit einer typischen Frequenz von 100 kHz und einer Flankensteilheit in einer Größenordnung von 50 V/ps erzeugt, einzukoppeln, zu transportieren und zu verarbeiten. Dies kann zum Beispiel für Anwendungen relevant sein, bei denen eine Impedanzanpassung durch einen verbreiterungsfreien Übergang bewerkstelligt werden soll. Es soll aber betont werden, dass andere Ausführungsbeispiele der Erfindung in ganz anderen Frequenzbereichen operieren können.

Gemäß einem exemplarischen Ausführungsbeispiel kann die Vorrichtung als gedruckte Leiterplatte ausgebildet sein. Eine Leiterplatte (Leiterkarte, Platine oder gedruckte Schaltung; Printed Circuit Board, PCB) kann als ein Träger für elektronische Bauteile bezeichnet werden. Eine Leiterplatte dient der mechanischen Befestigung und elektrischen Verbindung. Leiterplatten weisen elektrisch isolierendes Material als Trägerstruktur mit daran haftenden, leitenden Verbindungen, d.h. Leiterbahnen und Kontaktstrukturen, auf. Als isolierendes Material ist faserverstärkter Kunststoff möglich. Die Leiterbahn(en) kann/können aus einer dünnen Schicht Kupfer geätzt werden.

Gemäß einem exemplarischen Ausführungsbeispiel kann ein Durchmesser der Kontaktstruktur und/oder der Leiterbahn in einem Bereich zwischen ungefähr 1 µm und ungefähr 100 µm sein, insbesondere in einem Bereich zwischen ungefähr 10 µm und ungefähr 30 µm. Gerade bei solchen für Leiterplatten äußerst geringen Dimensionen, bei denen Welleneigenschaften von Hochfrequenzsignalen maßgeblich werden, ist die verbreiterungsfreie Übergangsstelle zwischen Kontaktstruktur und Leiterbahn besonders vorteilhaft.

Gemäß einem exemplarischen Ausführungsbeispiel kann die Trägerstruktur aus mehreren übereinander angeordneten Schichten gebildet sein, wobei die Vorrichtung ferner zumindest eine weitere elektrisch leitfähige Struktur (zum Beispiel in Form mindestens einer weiteren Leiterbahn) zwischen den Schichten aufweist. Die elektronische Anordnung kann somit als Mehrschichtstruktur ausgebildet werden, in der elektrische Signale zwischen unterschiedlichen Schichten in horizontaler und/oder vertikaler Richtung übertragen werden. Dadurch können auch komplexe schaltungstechnische Aufgaben mit der erfindungsgemäßen Vorrichtung umgesetzt werden.

Die Leiterbahn und die Kontaktstruktur werden in einer gemeinsamen, insbesondere simultanen oder unterbrechungsfreien, Prozedur gebildet. Das gleichzeitige Ausbilden von Leiterbahn(en) und Kontaktstruktur(en) stellt dabei sicher, dass der Übergang homogen und verbreitungsfrei ausgebildet werden kann. Sich aufsummierende Einzeltoleranzen bei einem separaten Herstellen von Leiterbahnen und einem separaten Herstellen von Kontaktstrukturen bei herkömmlichen Ansätzen führen zu der Notwendigkeit, überbrückende Verbindungstrukturen in Formen von Pads vorzusehen, um ungeachtet der Toleranzen zuverlässig eine elektrische Kopplung einer Leiterbahn mit einer Kontaktstruktur zu ermöglichen. Dies kann bei einem simultanen Definieren der Positionen von Leiterbahn und Kontaktstruktur in einer gemeinsamen Prozedur (insbesondere in einem gemeinsam gebildeten Hohlraum in der Trägerstruktur) vermieden werden, da dann keine sich voneinander unabhängig aufsummierenden Toleranzen auftreten.

Gemäß einem exemplarischen Ausführungsbeispiel kann in der Trägerstruktur eine sich in diese hinein erstreckende Kontaktöffnung gebildet werden, die nachfolgend mit elektrisch leitfähigem Material gefüllt wird, um dadurch die Kontaktstruktur zu bilden. Die Kontaktöffnung kann ein vertikales Sackloch oder Durchgangsloch durch die Trägerstruktur sein.

Gemäß einem exemplarischen Ausführungsbeispiel kann bei dem Verfahren mittels Materialabtrags an der Oberfläche der Trägerstruktur eine Nut (insbesondere eine längliche Vertiefung in der Trägerstruktur) gebildet und nachfolgend mit elektrisch leitfähigem Material gefüllt werden, um dadurch die Leiterbahn zu bilden. Entsprechend kann bei der Vorrichtung die Leiterbahn als mit elektrisch leitfähigem Material gefüllte Nut in der Oberfläche der Trägerstruktur gebildet sein. Die Nut und die Kontaktöffnung können zusammenhängend ausgebildet werden und unmittelbar aneinander anschließen. Nut und Kontaktöffnung bilden anschaulich das Negativ oder die Inversstruktur zu Leiterbahn und Kontaktstruktur.

Alternativ zum Ausbilden einer Nut, die dann mit elektrisch leitfähigem Material aufgefüllt wird, kann das elektrisch leitfähige Material auch auf einer planen Oberfläche der Trägerstruktur abgeschieden werden, um die Leiterbahnen zu bilden. Das Ausbilden einer Nut hat allerdings den Vorteil, dass simultan damit auch eine Kontaktöffnung (insbesondere als Sackloch in der oder Durchgangsloch durch die Trägerstruktur) zum späteren Bilden der Kontaktstruktur hergestellt werden kann, womit vorteilhaft eine gemeinsame Definition der räumlichen Positionen von Kontaktstruktur und Leiterbahnen (vorzugsweise in einem gemeinsamen trägerstrukturmaterialabtragenden Verfahren) ermöglicht wird, so dass durch Füllung der gebildeten Hohlstrukturen mit elektrisch leitfähigem Material Kontaktstruktur und Leiterbahnen vollendet werden können, ohne dass ein Verbindungspad notwendig ist.

Gemäß einem exemplarischen Ausführungsbeispiel kann zumindest eine der Nut und der Kontaktöffnung, vorzugsweise beide, mittels Lasergrooving gebildet werden. Mit einem Laserstrahl kann eine zweidimensionale Oberfläche der Trägerstruktur abgescannt werden, wodurch unter Abfahren einer gemeinsamen Trajektorie in der Oberfläche Nuten bzw. Kontaktlöcher geformt werden, wobei die Verweilzeit des Lasers an einer bestimmten Position die Tiefe der Nut bzw. des Kontaktlochs definiert. Insbesondere ist die Verweilzeit in den Oberflächenbereichen, in denen die Nut (mit relativ geringer Tiefe) zu bilden ist, kürzer als die Verweilzeit in den Oberflächenbereichen, in denen ein Kontaktloch (mit relativ großer Tiefe) zu bilden ist. Dadurch kann in einem gemeinsamen Prozess sowohl die Leiterbahn als auch die damit zusammenhängende Kontaktstruktur definiert werden, die auch ohne ein Pad oder eine andere Verbreiterungsstruktur zuverlässig elektrisch leitfähig miteinander verbunden sind.

Gemäß einem exemplarischen Ausführungsbeispiel kann zumindest eine der Nut und der Kontaktöffnung, vorzugsweise beide, mittels eines Lithographie-und Ätzverfahrens gebildet werden. Hierzu kann zunächst ein Photoresist (oder ein anderer Resist) auf einer Oberfläche der Trägerstruktur abgeschieden werden. Mittels Belichtens und nachfolgenden Entfernens eines Teils des Photoresists kann dann ein Bereich der Oberfläche der Trägerstruktur freigelegt werden. Der freigelegte Oberflächenbereich kann dann mittels einer Ätzbehandlung bearbeitet werden, wodurch abhängig von der Dauer des Ätzprozesses bzw. abhängig von der Ätzrate eines jeweiligen Materialabschnitts der Trägerstruktur eine Nut (relativ kurzes Ätzen bzw. Ätzen eines Materialabschnitts der Trägerstruktur mit relativ geringer Ätzrate) bzw. eine Kontaktöffnung (relativ langes Ätzen bzw. Ätzen eines Materialabschnitts der Trägerstruktur mit relativ hoher Ätzrate) mit definierbarer Tiefe erzeugt werden kann. Vorteilhaft wird das Lithographieverfahren (und optional auch das Ätzverfahren) zumindest abschnittsweise zeitlich gemeinsam zum Definieren von Nut und Kontaktloch in einer gemeinsamen Prozedur durchgeführt.

Gemäß noch einem anderen exemplarischen Ausführungsbeispiel kann zumindest eine der Nut und der Kontaktöffnung, vorzugsweise beide, mittels Prägens in der Trägerstruktur ausgebildet werden. Ein auf eine Oberfläche der Trägerstruktur einwirkender Prägestempel oder dergleichen kann ebenfalls in einer gemeinsamen Prozedur eine Nut als Basis zum Erzeugen der Leiterbahn und eine Kontaktöffnung als Basis zum Erzeugen der Kontaktstruktur definieren, ohne dass es des Vorsehens eines Pads oder einer sonstigen Verbreiterung an einer Übergangsstelle bedarf.

Gemäß einem exemplarischen Ausführungsbeispiel kann sich eine Prozedur des Definierens einer Gestalt der Leiterbahn und eine Prozedur des Definierens einer Gestalt der Kontaktstruktur unterbrechungsfrei aneinander anschließen oder (zeitlich deckungsgleich oder zumindest zeitlich überlappend) simultan miteinander durchgeführt werden. Dadurch kann vermieden werden, dass sich bei separaten Prozessen aufsummmierende Toleranzen zur Notwendigkeit des Vorsehens eines Pads zwischen Leiterbahn und Kontaktstruktur führen. Bei horizontal und vertikal in einem gemeinsamen, gleichzeitigen Prozess definierten Dimensionen können herkömmliche Registraturprobleme zwischen Leiterbahnen und Kontaktstrukturen vermieden werden und somit Pads entbehrlich gemacht werden.

Gemäß einem exemplarischen Ausführungsbeispiel der Erfindung ist eine Leiterplattendurchkontaktierung geschaffen, wobei die zugehörige Leiterplatte in ihrem Inneren andere Komponenten integrieren kann. Durchkontaktierungen einer solchen Leiterplatte können durch nur einen oder alle Layer gehen und derart ausgeführt sein, dass die zu- oder abführende Leiterbahn ohne Verbreiterung direkt in die Durchkontaktierung geführt wird. Die erreichbaren Energieeinsparungen sind besonders hoch, wenn die Bohrlochgröße unter 100 Mikrometer ist, vorzugsweise unter 30 Mikrometer ist. Die Flankensteilheit der durchgeleiteten Signale kann vorteilhaft über 200 V pro 50 Pikosekunden liegen. Das Basismaterial einer Leiterplatte gemäß einem exemplarischen Ausführungsbeispiel kann FR 4, Glas und/oder ein glasartiges Trägermaterial sein. Bei einer zugehörigen Durchkontaktierung kann eine eingebettete elektronische Komponente in der Leiterplatte integriert sein.

Fachleute werden verstehen, dass der verbreiterungsfreie Übergang zwischen der Leiterbahn und der Kontaktstruktur an der Verbindungsstelle auch dann realisiert ist, wenn im Rahmen von technisch (insbesondere herstellungsbedingt) unvermeidbaren Toleranzen an der Verbindungsstelle eine geringfügige Verbreiterung auftritt, die solche Toleranzen nicht überschreitet. Von einer Verbreiterungsfreiheit im Sinne der beanspruchten Erfindung kann insbesondere ausgegangen werden, wenn die Verbreiterung nur so geringfügig ist, dass keinerlei Störungen in der Signalausbreitung auftreten. Die genannten Toleranzen können zum Beispiel während eines Lithographieverfahrens entstehen, wenn geringfügige Abweichungen von lithographischen Soll-Bedingungen auftreten. Dadurch kann es zu geringfügigen Abweichungen von einer vollständigen Verbreiterungsfreiheit kommen. Bei Ausführungsbeispielen der Erfindung ist eine etwaige geringe Restverbreiterung aber in jedem Fall geringer als beim herkömmlichen Zwischenordnen eines Pads zwischen Leiterbahn und Kontaktstruktur. In entsprechender Weise kann es an jeder Stelle des Leiterquerschnitts zu technischen Toleranzen kommen, die über den Leiterquerschnitt hinweg zu etwas ungleichmäßigen Breiten, Dicken bzw. Durchmessern führen können.

Im Folgenden werden exemplarische Ausführungsbeispiele der vorliegenden Erfindung mit Verweis auf die folgenden Figuren detailliert beschrieben.
Figur 1 zeigt eine räumliche Ansicht einer elektronischen Vorrichtung gemäß einem exemplarischen Ausführungsbeispiel der Erfindung.
Figur 2 zeigt eine Querschnittsansicht der elektronischen Vorrichtung gemäß Figur 1 samt einem schematisch dargestellten Hochfrequenzsignal, das durch einen Leiterzug der Vorrichtung propagiert.
Figur 3 zeigt eine Draufsicht einer herkömmlichen elektronischen Vorrichtung mit einem Pad zwischen einer Leiterbahn und einem Via sowie einer Draufsicht einer elektronischen Vorrichtung gemäß einem exemplarischen Ausführungsbeispiel der Erfindung, bei der ein Übergang zwischen einer Leiterbahn und einem Via pad- und verbreiterungsfrei ausgebildet ist.
Figur 4 zeigt eine Querschnittsansicht einer elektronischen Vorrichtung gemäß einem exemplarischen Ausführungsbeispiel der Erfindung mit eingebetteten elektronischen Komponenten.
Figur 5 und Figur 6 zeigen eine Anordnung während eines Verfahrens zum Herstellen einer elektronischen Vorrichtung gemäß einem exemplarischen Ausführungsbeispiel der Erfindung, bei der mittels eines Lithographie- und Ätzverfahrens eine Nut und eine Kontaktöffnung in einer elektrisch isolierenden Trägerstruktur gebildet werden.
Figur 7 zeigt die Anordnung gemäß Figur 5 und Figur 6 zu einem späteren Zeitpunkt, bei dem die Nut und die Kontaktöffnung mit elektrisch leitfähigem Material gefüllt werden.
Figur 8 zeigt eine Anordnung während eines Verfahrens zum Herstellen einer elektronischen Vorrichtung gemäß einem exemplarischen Ausführungsbeispiel der Erfindung, bei der mittels Embossing (Prägen) eine Nut und eine Kontaktöffnung in einer elektrisch isolierenden Trägerstruktur gebildet werden, in der bereits eine elektrisch zu kontaktierende elektronische Komponente eingebettet ist.
Figur 9 zeigt eine Anordnung während eines Verfahrens zum Herstellen einer elektronischen Vorrichtung gemäß einem exemplarischen Ausführungsbeispiel der Erfindung, bei der mittels Lasergrooving eine Nut und eine Kontaktöffnung in einer elektrisch isolierenden Trägerstruktur gebildet werden.
Figur 10 zeigt die Anordnung gemäß Figur 9 zu einem späteren Zeitpunkt, bei dem die Nut und die Kontaktöffnung mit elektrisch leitfähigem Material gefüllt werden.

Gleiche oder ähnliche Komponenten in unterschiedlichen Figuren sind mit gleichen Bezugsziffern versehen.

Bevor bezugnehmend auf die Figuren exemplarische Ausführungsbeispiele der Erfindung beschrieben werden, sollen noch einige allgemeine Aspekte der Erfindung erläutert werden:
Gemäß exemplarischen Ausführungsbeispielen kann eine Reduktion des Energieverbrauchs von in einer Leiterplatte eingebetteten Komponenten erreicht werden.

Im Rahmen von Einbettungsverfahren zum Einbetten von elektronischen Komponenten in eine Leiterplatte wurde festgestellt, dass der tatsächliche Energieverbrauch häufig über dem errechneten liegt. Durch Untersuchungen konnte festgestellt werden, dass vor allem die im Moment herstellprozessbedingten Design-Rules für Leiterplattendesign und HDI-Leiterplattendesign durch die Vorgabe eines Pads um einen Durchkontaktierungspunkt herum einen relevanten Anteil an parasitären Effekten generieren und dadurch mit zunehmender Frequenz eine überproportionale Zunahme der Störungen verursachen. Des Weiteren wurde gefunden, dass ab gewissen hohen Frequenzen durch diese Pads auch die Ausbildung von parasitären Moden gefördert wird.

Es wurde nun durch die vorliegenden Erfinder erstaunlicherweise gefunden, dass durch die Weglassung dieser Pads für ein Via und unter Verwendung der dabei besonders vorteilhaften ultrapräzisen Bohrungen (zur Minimierung von mechanischen Falschpositionierungen) die Energieverbrauchswerte in großen Zügen mit den theoretischen Werten in Einklang gebracht werden können. Ebenfalls erstaunlicherweise begünstigt diese Weglassung von Pads auch die Unterdrückung von parasitären Moden, da durch die direkte Ankopplung von Vias und Mikrovias an die Leiterbahnen eine störungsärmere (und dadurch modenärmere) Ankopplung an die Übergänge stattfinden kann.

Es wurde weiter gefunden, dass diese Einbettung des Via direkt in die Leiterbahn ohne zusätzlichen Pad auch eine bevorzugte Ankopplungsart für einen Hohlleiter darstellt.

Jedes Via wird bei sehr hohen Frequenzen auch zu einem Hohlleiter - und genau die Ankopplung an diesen Hohlleiter ist ohne Pad mit deutlich weniger parasitären Effekten verbunden. Dabei wurde auch festgestellt, dass diese Hohlleiterfunktion sich bereits bei tieferen Frequenzen einstellt als λ/4 bzw. λ/2 des Resonatorenraumes, wobei λ die Wellenlänge des propagierenden Hochfrequenzsignals ist.

Es wurde weiter gefunden, dass auch metallgefüllte Vias ab bestimmten Frequenzen durch den Skineffekt zu einem Hohlleiter werden und sich auch da diese optimierenden Effekte einstellen. Gerade bei hohen Frequenzen zeigen sich diese parasitären Effekte besonders stark und lassen sich durch das Weglassen der Pads besonders wirkungsvoll reduzieren.

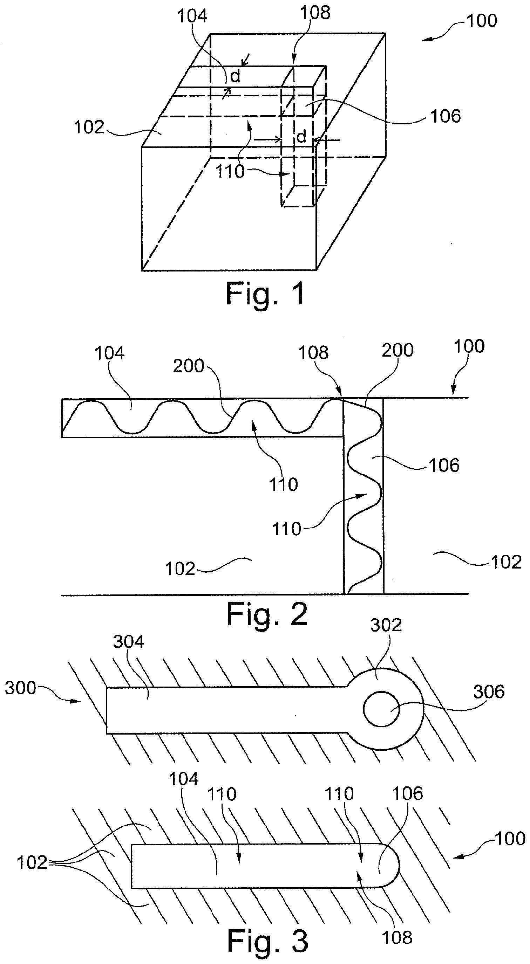

**Figur 1** zeigt eine räumliche Ansicht einer als Leiterplatte ausgebildeten elektronischen Vorrichtung 100 gemäß einem exemplarischen Ausführungsbeispiel der Erfindung.

Die elektronische Vorrichtung 100 weist eine elektrisch isolierende Trägerstruktur 102 auf, die aus einer Mischung von Glasfasern und Epoxidharz gebildet ist. Eine elektrisch leitfähige Leiterbahn 104 aus Kupfer ist an einer Oberfläche der Trägerstruktur 102, genauer gesagt in einer Nut in der Oberfläche der Trägerstruktur 102, gebildet. Alternativ kann die Leiterplatte 104 auch erhaben über eine ebene Oberfläche der elektrisch isolierenden Trägerstruktur 102 hervorstehen. Ferner ist eine elektrisch leitfähige Kontaktstruktur 106 aus Kupfer vorgesehen, die sich als Via ausgehend von der Oberfläche der Trägerstruktur 102 vertikal in die Trägerstruktur 102 hinein und durch die gesamte Trägerstruktur 102 hindurch bis zu einer gegenüberliegenden Oberfläche der Trägerstruktur 102 erstreckt. Unter Bildung eines gemeinsamen Leiterzugs 110 ist die Kontaktstruktur 106 an einer Verbindungsstelle 108 an die Leiterbahn 104 unmittelbar bzw. direkt elektrisch angeschlossen. Somit gehen an der Verbindungsstelle 108 die Leiterbahn 104 und die Kontaktstruktur 106 verbreiterungsfrei ineinander über.

Eine Breite bzw. eine Dicke der Leiterbahn 104 an einer Seite der Verbindungsstelle 108 ist gleich einer Breite bzw. einer Dicke der Kontaktstruktur 106 an der anderen Seite der Verbindungsstelle 108. Ein Durchmesser d der Kontaktstruktur 106 und der Leiterbahn 104 beträgt in dem gezeigten Ausführungsbeispiel 30 µm. Die Verbindungsstelle 108 ist padfrei ausgebildet, das heißt koppelt die Kontaktstruktur 106 mit der Leiterbahn 104 unmittelbar und ohne dazwischen angeordnetes Pad. Die Leiterbahn 104 und die Kontaktstruktur 106 weisen im Bereich der Verbindungsstelle 108 und auch entlang der gesamten Erstreckung der Leiterbahn 104 und der Kontaktstruktur 106, einen konstanten rechteckförmigen Querschnitt hinsichtlich Querschnittsfläche und Querschnittsform auf. Auch im Bereich der Verbindungsstelle 108 sind die Leiterbahn 104 und die Kontaktstruktur 106 homogen aus Kupfer-Material gebildet, das in einem gemeinsamen Verfahren auf die Trägerstruktur 102 aufgebracht bzw. darin eingebracht wird. Daher gehen die Leiterbahn 104 und die Kontaktstruktur 106 nahtfrei ineinander über. Die Verbindung kann auch als "Landless" bezeichnet werden.

**Figur 2** zeigt eine Querschnittsansicht der elektronischen Vorrichtung 100 gemäß Figur 1 samt einem schematisch dargestellten Hochfrequenzsignal, das durch einen Leiterzug 110 der Vorrichtung 100 propagiert. Figur 2 ist zu entnehmen, dass die Verbindungsstelle 108 aufgrund ihrer Homogenität für das schematisch dargestellte Hochfrequenzsignal 200 praktisch keine Barriere darstellt, so dass es an dieser Stelle nicht zum Ausbilden unerwünschter Moden oder anderer parasitärer Effekte kommt.

Indem der Übergang zwischen der Leiterbahn 104 und der Kontaktstruktur 106 verbreiterungsfrei und padfrei ausgebildet ist, bietet sich einem elektrischen Signal, und in besonderer Weise einem Hochfrequenzsignal 200, ein homogener und störungsfreier Propagationspfad durch den gesamten Leiterzug 110, so dass insbesondere an der Verbindungsstelle 108 keine nennenswerte Signaldämpfung stattfindet. Dadurch ist ein energiesparender Betrieb der elektronischen Vorrichtung 100 möglich. Indem ein Pad oder eine Verbreiterung elektrisch leitfähiger Strukturen an der Verbindungsstelle 108 entbehrlich sind, können sich Hochfrequenzsignale bei höchsten Frequenzen von 100 GHz und mehr annähernd verlustfrei durch den Leiterzug 110 hindurch bewegen. Aufgrund des Skineffekts propagieren solche Hochfrequenzsignale im Wesentlichen in einem oberflächlichen Hülsenbereich des Leiterzugs 110 und bilden somit anschaulich sich ideal ausbreitende Hohlwellen aus. Daher ist die "Landless"-Architektur gemäß Figur 1 und Figur 2 so konfiguriert, dass sie besonders vorteilhaft für den Transport von Hochfrequenzsignalen geeignet ist.

**Figur 3** zeigt eine Draufsicht einer herkömmlichen elektronischen Vorrichtung 300 mit einem Pad 302 zwischen einer Leiterbahn 304 und einem Via 306. Aufgrund der mechanischen Inhomogenität im Bereich des Übergangs zwischen der Leiterbahn 304 und dem Via 306 durch das breite Pad 302 kommt es in diesen Bereich herkömmlich zu Energieverlustmechanismen eines propagierenden elektrischen Signals, insbesondere eines hochfrequenten Signals. Im Gegensatz dazu zeigt eine in Figur 3 ebenfalls dargestellte Draufsicht einer elektronischen Vorrichtung 100 gemäß einem exemplarischen Ausführungsbeispiel der Erfindung einen pad- und verbreiterungsfreien Übergang an einer Verbindungsstelle 108 zwischen einer Leiterbahn 104 und einem Via 106.

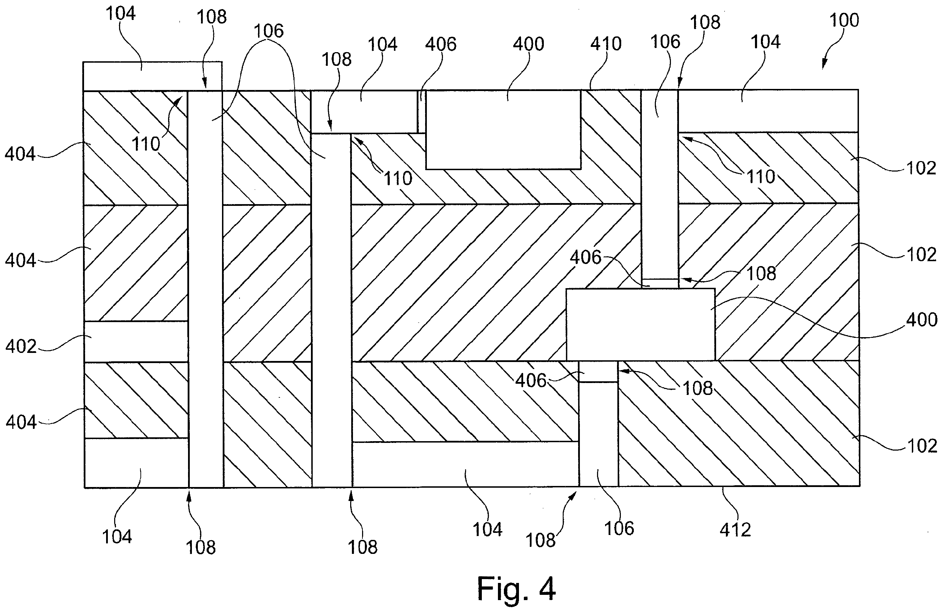

**Figur 4** zeigt eine Querschnittsansicht einer als Multilayer-Leiterbahn ausgebildeten elektronischen Vorrichtung 100 gemäß einem exemplarischen Ausführungsbeispiel der Erfindung mit eingebetteten elektronischen Komponenten 400.

Die Trägerstruktur 102 ist aus mehreren übereinander angeordneten dielektrischen Schichten 404 gebildet, die zum Beispiel aus harzgetränkten Glasfasermatten (Prepreg-Material) gebildet sein können und miteinander verpresst sein können. Die Vorrichtung 100 enthält ferner eine weitere elektrisch leitfähige Struktur 402 in Form einer strukturierten elektrisch leitfähigen Schicht zwischen den Schichten 404, die zum Beispiel ebenfalls zwischen den Schichten 404 verpresst sein kann.

Die Vorrichtung 100 weist mehrere Leiterbahnen 104 auf der Trägerstruktur 102 auf, die sich an beiden gegenüberliegenden Hauptoberflächen 410, 412 der Trägerstruktur 102 befinden.

Die Vorrichtung 100 weist darüber hinaus elektronische Komponenten 400 auf, die in der Trägerstruktur 102 eingebettet sind ("embedded components") und jeweils mit einer von mehreren vertikalen Kontaktstrukturen 106 und/oder mit einer oder mehreren von horizontalen Leiterbahnen 104 elektrisch leitfähig gekoppelt sind. Kontaktstrukturen 106 und Leiterbahnen 104 sind miteinander an jeweiligen Verbindungsstellen 108 unter Ausbildung eines jeweiligen Leiterzugs 110 padfrei elektrisch leitfähig gekoppelt. An einer anderen Verbindungsstelle 108 gehen ein elektrischer Kontakt 406 der elektronischen Komponente 400 und die Kontaktstruktur 106 verbreiterungsfrei ineinander über. An weiteren Verbindungsstellen 108 gehen ein elektrischer Kontakt 406 der elektronischen Komponente 400 und eine jeweilige Leiterbahn 104 verbreiterungsfrei ineinander über.

Eine der elektronischen Komponenten 400 ist als Treibereinrichtung konfiguriert, die zum Einkoppeln eines Hochfrequenzsignals (siehe Bezugszeichen 200 in Figur 2) in den angeschlossenen Leiterzug 110 ausgebildet ist, wobei das Hochfrequenzsignal zum Beispiel eine Frequenz von 500 GHz hat. Eine Flankensteilheit des Hochfrequenzsignals ist vorzugsweise größer als 200 V pro 50 ps.

Wie Figur 4 zu entnehmen ist, ist jeder der Übergänge 108 zwischen einer Leiterbahn 104/einer Kontaktstruktur 106/einem elektrischen Kontakt 406 einer elektronischen Komponente 400 pad- und verbreiterungsfrei ausgebildet. Dadurch ist die mehrschichtige Vorrichtung 100 in ihrer Betriebsweise extrem energiesparend, kompakt und einfach fertigbar sowie in annähernd beliebiger elektronischer Komplexität konfigurierbar.

Zum Beispiel kann die in der mittleren Schicht 404 eingebettete elektronische Komponente 400 als die Treibereinrichtung zum Erzeugen eines hochfrequenten Signals eingesetzt werden, das über den an der Unterseite der elektronischen Komponente 400 gebildeten elektronischen Kontakt 406, eine vertikale Kontaktstruktur 108, eine an der Unterseite der Vorrichtung 100 angeordnete Leiterbahn 104, eine vertikale Kontaktstruktur 106, eine an der Oberseite der Vorrichtung 100 angeordnete Leiterbahn 104, einen weiteren elektrischen Kontakt 406 bis hin zu der an der oberen Oberfläche der Vorrichtung 100 freigelegten elektronischen Komponente 400 (zum Beispiel ausgebildet als Sensor) geleitet werden kann. Da alle Übergänge 108 verbreiterungsfrei ausgebildet sind, kann das Signal ungehindert und somit ohne Energie- und Qualitätsverluste durch die Vorrichtung 100 propagieren.

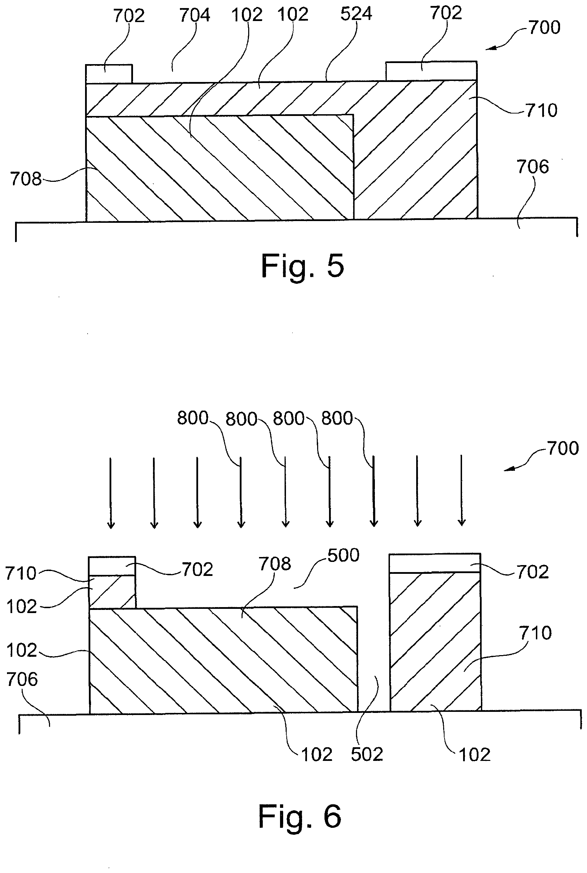

**Figur 5** und **Figur 6** zeigen eine Anordnung 700, die während eines Verfahrens zum Herstellen einer elektronischen Vorrichtung 100 gemäß einem exemplarischen Ausführungsbeispiel der Erfindung eingesetzt werden kann. Bei diesem Herstellungsverfahren werden eine Nut 500 und eine Kontaktöffnung 502 beide mittels eines gemeinsamen Lithographieverfahrens (siehe Figur 5) und Ätzverfahrens (siehe Figur 6) gebildet. Während der Durchführung des Lithographie- und Ätzverfahrens kann die Trägerstruktur 102 auf einem temporären Träger 706 angeordnet werden.

Bei dem in Figur 5 schematisch dargestellten Lithographieverfahren wird ein Resist 702 auf der Hauptoberfläche 524 der Trägerstruktur 102 aufgebracht und mittels Belichtens unter Verwendung einer Maske strukturiert. Dadurch wird eine Zugangsöffnung 704 definiert, an der ein nachfolgendes Ätzverfahren Material der elektrisch isolierenden Trägerstruktur 102 angreifen kann.

Gemäß dem in Figur 6 dargestellten Ätzverfahren erfolgt ein schematisch mit Bezugszeichen 800 dargestellter Ätzangriff, der selektiv Material der Trägerstruktur 102 mittels Ätzens entfernt, das an der Zugangsöffnung 704 freigelegt und nicht mit dem verbleibenden Resist 702 bedeckt ist. Das Ätzen kann zum Beispiel mittels Plasmaätzen, chemischem Ätzen, Nassätzen oder Trockenätzen durchgeführt werden. Figur 6 zeigt ferner, dass in dem gezeigten Ausführungsbeispiel die Trägerstruktur 102 eine Ätzstoppstruktur 708 aufweist, die aus einem Material gebildet ist, das während der Ätzprozedur vor einem Entfernen mittels Ätzens geschützt bleibt. Dagegen kann ätzbares Material 710 der elektrisch isolierenden Trägerstruktur 102 während des Ätzverfahrens mittels Ätzens entfernt werden. Ist die Position der Ätzstoppstruktur 708 bekannt, so können mit einem einzigen Ätzverfahren gleichzeitig die Nut 500 und die Kontaktöffnung 502 positionsgenau und ohne Registraturprobleme, mithin ohne das Erfordernis des Vorsehens von Pads zum Ausgleichen von relativen Positionstoleranzen, erzeugt werden.

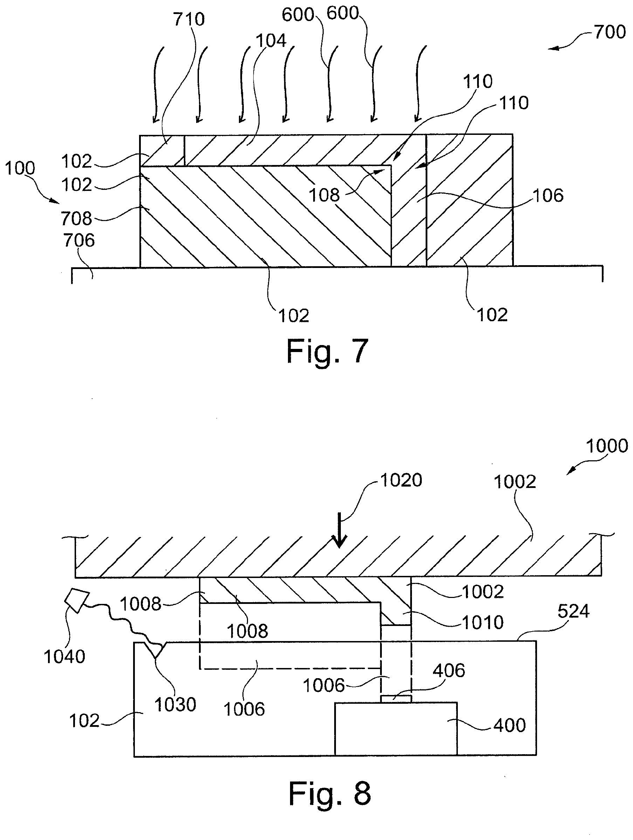

**Figur 7** zeigt die Anordnung 700 gemäß Figur 5 und Figur 6 zu einem späteren Zeitpunkt, bei dem die Nut 500 und die Kontaktöffnung 502 mit elektrisch leitfähigem Material gefüllt werden. Das Abscheideverfahren zum Abscheiden von elektrisch leitfähigen Material, siehe Bezugszeichen 600, kann wie gemäß Figur 6 durchgeführt werden.

**Figur 8** zeigt eine Anordnung 1000, die während noch einem anderen Verfahren zum Herstellen einer elektronischen Vorrichtung 100 gemäß einem exemplarischen Ausführungsbeispiel der Erfindung eingesetzt werden kann, bei dem mittels Embossing (Prägen) eine Nut 500 und eine Kontaktöffnung 502 in einer elektrisch isolierenden Trägerstruktur 102 gebildet werden, in der bereits eine elektrisch zu kontaktierende elektronische Komponente 400 eingebettet ist.

Gemäß Figur 8 wird ein Prägestempel 1002 auf die Hauptoberfläche 524 der Trägerstruktur 102 aufgepresst (siehe Bezugszeichen 1020). Indem der Prägestempel 1002 an seiner Oberfläche mit einem Negativprofil 1004 versehen ist, kann durch die Formgebung des Negativprofils 1004 die Form eines Prägelochs 1006 in der Trägerstruktur 102 vorgegeben werden. Das Negativprofil 1004 weist einen Nutformabschnitt 1008 zum Bilden der Nut 500 und einen Kontaktöffnungsformabschnitt 1010 zum Bilden der Kontaktöffnung 502 auf.

Optional kann ein Ausrichtungsmarker 1030, zum Beispiel eine Oberflächenkerbe, an der Trägerstruktur 102 vorgesehen werden, um zum Beispiel optisch (siehe Detektor 1040) eine korrekte Positionierung des Prägestempels 1002 relativ zu dem Trägerkörper 102 sicherzustellen.

Ein nachfolgendes Abscheideverfahren zum Abscheiden von elektrisch leitfähigen Material kann zum Beispiel mittels Sputterns, chemischer Gasphasenabscheidung, etc. erfolgen.

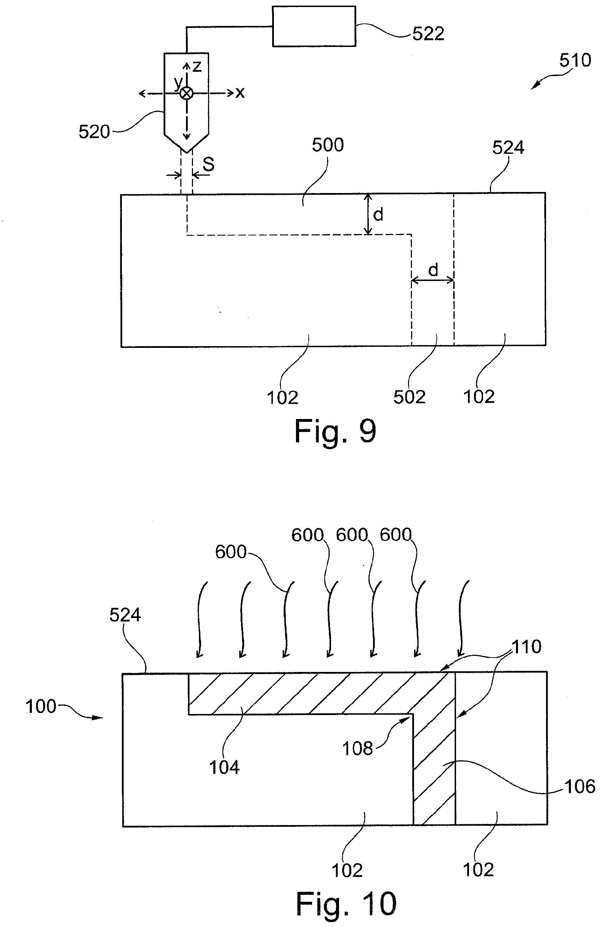

**Figur 9** zeigt eine Anordnung 510, die zum Durchführen eines Verfahrens zum Herstellen einer elektronischen Vorrichtung 100 gemäß einem exemplarischen Ausführungsbeispiel der Erfindung eingesetzt werden kann. Bei dem Verfahren können mittels Lasergrooving eine an einer Hauptoberfläche 524 einer elektrisch isolierenden Trägerstruktur 102 horizontal verlaufende Nut 500 und eine sich vertikal durch die elektrisch isolierende Trägerstruktur 102 hindurcherstreckende Kontaktöffnung 502 gebildet werden.

Ein Laser 520, der mittels einer Steuereinrichtung 522 steuerbar und entlang aller drei zueinander orthogonaler Raumrichtungen (x, y und z) mit an einer jeweiligen Position einstellbarer Verweildauer entlang einer vorgebbaren Trajektorie entlang der Hauptoberfläche 524 der elektrisch isolierenden Trägerstruktur 102 verfahrbar ist, ist zum Bilden von Vertiefungen in der Hauptoberfläche 524 der elektrisch isolierenden Struktur 102 mittels Lasergrooving ausgebildet. Die Steuereinrichtung 522 arbeitet ein entsprechendes Steuerprogramm ab, mit dem der Laser 520 entlang der vorgegebenen Trajektorie und somit mit einem einstellbaren Bewegungsprofil in der xy-Ebene verfahren wird und dabei an jeder Position für eine vorgegebene Verweildauer verbleibt. Dadurch kann ein Oberflächenprofil einer definierbaren Tiefenverteilung erzeugt werden, und dadurch auch eine dem Leiterzug 110 entsprechende bzw. hierzu inverse Aussparung gebildet werden. Die Aussparung bildet die Nut 500 und die sich daran unmittelbar anschließende und somit damit zusammenhängende Kontaktöffnung 502. Da eine Breite s (zum Beispiel 8 µm) des Laserstrahls wesentlich kleiner als eine einzustellende Dicke d (zum Beispiel 50 µm) der Nut 500 bzw. der Kontaktöffnung 502 ist, ist eine präzise Definition der Form der Nut 500 und der Kontaktöffnung 502 in einer gemeinsamen Prozedur möglich.

Figur 5 veranschaulicht somit die Durchführung eines ersten Abschnitts eines Verfahrens zum Herstellen einer elektronischen Vorrichtung 100, wobei bei dem Verfahren zunächst als Ausgangsstruktur eine elektrisch isolierende Trägerstruktur 102 bereitgestellt wird. Bei dem Verfahren wird mittels Materialabtrags an der Oberfläche der Trägerstruktur 102 die Nut 500 gebildet. Ferner wird in einer mit der Nutbildung gemeinsamen Prozedur in der Trägerstruktur 102 die sich in diese hinein erstreckende Kontaktöffnung 502 gebildet. Somit werden aufgrund des unterbrechungsfrei durchgeführten Lasergrooving-Verfahrens die Nut 500 und die Kontaktöffnung 502 in einer gemeinsamen, simultanen und unterbrechungsfreien Prozedur gebildet.

Die Nut 500 und die Kontaktöffnung 502 werden nachfolgend, wie in Figur 10 gezeigt, mit elektrisch leitfähigem Material gefüllt, um dadurch die Kontaktstruktur 106 zu bilden.

Bei dem Verfahren gemäß Figur 9 schließt sich eine Prozedur des Definierens einer Gestalt der Kontaktstruktur 106 (als Inverse des Kontaktlochs 502) unterbrechungsfrei an eine Prozedur des Definierens einer Gestalt der Leiterbahn 104 (als Inverse der Nut 500) an. Dies macht vorteilhaft das Ausbilden einer Kontaktbrücke in Form eines Pads entbehrlich, wie dies bei zwei voneinander getrennten Prozeduren mit jeweils unterschiedlichen Toleranzen zum Ausgleich von Registraturproblemen herkömmlich erforderlich ist.

**Figur 10** zeigt die Anordnung 510 gemäß Figur 9 zu einem späteren Zeitpunkt, bei dem die Nut 500 und die Kontaktöffnung 502 mit elektrisch leitfähigem Material gefüllt werden, um dadurch die Leiterbahn 104 und die Kontaktstruktur 106 zu bilden.

Durch das Abscheiden des Materials, wie mit Bezugszeichen 600 angedeutet, erfolgt simultan das Ausbilden der elektrisch leitfähigen Leiterbahn 104 an einer Oberfläche der Trägerstruktur 102 und das Ausbilden einer elektrisch leitfähigen Kontaktstruktur 106, die sich ausgehend von der Oberfläche in die Trägerstruktur 102 hinein erstreckt und unter Bildung eines gemeinsamen Leiterzugs 110 an einer Verbindungsstelle 108 an die Leiterbahn 104 elektrisch angeschlossen wird. Dadurch gehen an der Verbindungsstelle 108 die Leiterbahn 104 und die Kontaktstruktur 106 verbreiterungsfrei ineinander über und weisen, auch an der Verbindungsstelle 108, eine stetige bzw. homogene Materialzusammensetzung auf. Somit werden aufgrund des gemeinsamen Abscheideverfahrens die Leiterbahn 104 und die Kontaktstruktur 106 in einer gemeinsamen, simultanen und unterbrechungsfreien Prozedur gebildet.

Das Abscheiden des Materials, siehe Bezugszeichen 600, kann zum Beispiel mittels Sputterns, chemischer Gasphasenabscheidung, etc. erfolgen.

Ergänzend ist darauf hinzuweisen, dass "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Herstellen einer elektronischen Vorrichtung (100), wobei das Verfahren aufweist:
Bereitstellen einer elektrisch isolierenden Trägerstruktur (102), wobei die Trägerstruktur (102) zumindest eines aus der Gruppe aufweist, welche besteht aus: einer harzhaltigen Platte, einem Glassubstrat, einem organischen Substrat;
Bilden einer elektrisch leitfähigen Leiterbahn (104) an einer Oberfläche der Trägerstruktur (102);
Bilden einer elektrisch leitfähigen Kontaktstruktur (106), die sich ausgehend von der Oberfläche in die Trägerstruktur (102) hinein erstreckt und unter Bildung eines gemeinsamen Leiterzugs (110) an einer Verbindungsstelle (108) an die Leiterbahn (104) elektrisch angeschlossen wird, wobei in der Trägerstruktur (102) eine sich in diese hinein erstreckende Kontaktöffnung (502) gebildet wird, die nachfolgend mit elektrisch leitfähigem Material gefüllt wird, um dadurch die Kontaktstruktur (106) zu bilden, so dass die Kontaktstruktur (106) als mit dem elektrisch leitfähigen Material gefülltes Sackloch oder Durchgangsloch in der Trägerstruktur (102) ausgebildet ist;
wobei an der Verbindungsstelle (108) die Leiterbahn (104) und die Kontaktstruktur (106) ineinander verbreiterungsfrei übergehend ausgebildet werden,
**dadurch gekennzeichnet, dass**
die Leiterbahn (104) und die Kontaktstruktur (106) zumindest im Bereich der Verbindungsstelle (108) einen konstanten Querschnitt aufweisen; und
eine Prozedur des Definierens einer Gestalt der Leiterbahn (104) und eine Prozedur des Definierens einer Gestalt der Kontaktstruktur (106) sich unterbrechungsfrei aneinander anschließen oder simultan miteinander durchgeführt werden.

2. Verfahren gemäß Anspruch 1, aufweisend:
die Leiterbahn (104) und die Kontaktstruktur (106) werden in einer gemeinsamen, insbesondere simultanen oder unterbrechungsfreien, Prozedur gebildet.

3. Verfahren gemäß Anspruch 1 oder 2, aufweisend:
bei dem Verfahren wird mittels Materialabtrags an der Oberfläche der Trägerstruktur (102) eine Nut (500) gebildet und nachfolgend mit elektrisch leitfähigem Material gefüllt, um dadurch die Leiterbahn (104) zu bilden.

4. Verfahren gemäß einem der Ansprüche 1 bis 3, aufweisend zumindest eines der folgenden Merkmale:
zumindest eine der Nut (500) und der Kontaktöffnung (502), vorzugsweise beide, wird oder werden mittels eines Lithographie- und Ätzverfahrens gebildet;
zumindest eine der Nut (500) und der Kontaktöffnung (502), vorzugsweise beide, wird oder werden mittels Prägens in der Trägerstruktur (102) ausgebildet;
zumindest eine der Nut (500) und der Kontaktöffnung (502), vorzugsweise beide, wird oder werden mittels Lasergrooving gebildet.

5. Verfahren gemäß einem der Ansprüche 1 bis 4, wobei die Verbindungsstelle (108) padfrei ausgebildet ist.

6. Verfahren gemäß einem der Ansprüche 1 bis 5, wobei die Leiterbahn (104) und die Kontaktstruktur (106) entlang der gesamten Erstreckung der Leiterbahn (104) und der Kontaktstruktur (106) einen konstanten Querschnitt aufweisen.

7. Verfahren gemäß einem der Ansprüche 1 bis 6, wobei sich die Kontaktstruktur (106) senkrecht zu einer Erstreckung der Leiterbahn (104) in die Trägerstruktur (102) hinein erstreckt und als Via ausgebildet ist.

8. Verfahren gemäß einem der Ansprüche 1 bis 7,
wobei zumindest im Bereich der Verbindungsstelle (108) die Leiterbahn (104) und die Kontaktstruktur (106) aus einem homogenen Material gebildet sind.

9. Verfahren gemäß einem der Ansprüche 1 bis 8, aufweisend eine elektronische Komponente (400), die in der Trägerstruktur (102) eingebettet ist und mit der Kontaktstruktur (106) und/oder der Leiterbahn (104) elektrisch leitfähig gekoppelt ist, insbesondere wobei die elektronische Komponente (400) ein Hochfrequenzbauteil aufweist.

10. Verfahren gemäß Anspruch 9, wobei an einer anderen Verbindungsstelle (108) ein elektrischer Kontakt (406) der elektronischen Komponente (400) einerseits und die Kontaktstruktur (106) oder die Leiterbahn (104) andererseits verbreiterungsfrei ineinander übergehen.

11. Verfahren gemäß einem der Ansprüche 1 bis 10, aufweisend eine andere Leiterbahn (104) in der Trägerstruktur (102), wobei an einer weiteren Verbindungsstelle (108) die andere Leiterbahn (104) und die Kontaktstruktur (106) verbreiterungsfrei ineinander übergehen.

12. Verfahren gemäß einem beliebigen der vorhergehenden Ansprüche, ferner aufweisend:
Bereitstellen einer Treibereinrichtung (400), die zum Einkoppeln eines Hochfrequenzsignals in den Leiterzug (110) ausgebildet ist.

13. Verfahren gemäß einem Anspruch 12,
wobei die Treibereinrichtung (400) zum Einkoppeln eines Hochfrequenzsignals in einem Frequenzbereich von mindestens 10 GHz ausgebildet ist.

## Claims

1. Method for manufacturing an electronic device (100), wherein the method comprises:
providing an electrically insulating carrier structure (102), wherein the carrier structure (102) comprises at least one of the group which is consisting of: a resin containing plate, a glass substrate, an organic substrate;
forming an electrically conductive conductor trace (104) at a surface of the carrier structure (102);
forming an electrically conductive contact structure (106) which extends originating from the surface into the carrier structure (102), and is electrically connected to the conductor trace (104) under formation of a common conductor path (110) at a connection location (108),
wherein in the carrier structure (102), a contact opening (502) is formed which extends into the carrier structure (102), which contact opening (502) is subsequently filled with electrically conductive material, to thereby form the contact structure (106), so that the contact structure (106) is formed as a blind hole or a through hole in the carrier structure (102) which is filled with the electrically conductive material;
wherein at the connection location (108), the conductor trace (104) and the contact structure (106) are formed in a merging manner without a broadening,
**characterized in that**
the conductor trace (104) and the contact structure (106) comprise a constant cross-section at least in the region of the connection location (108); and
a procedure of defining a shape of the conductor trace (104) and a procedure of defining a shape of the contact structure (106) are following each other without an interruption or are performed simultaneously.

2. Method according to claim 1, comprising:
the conductor trace (104) and the contact structure (106) are formed in a common, in particular simultaneous or interruption-free, procedure.

3. Method according to claim 1 or 2, comprising:
in the method, by a material removal at the surface of the carrier structure (102), a groove (500) is formed and is subsequently filled with electrically conductive material, to thereby form the conductor trace (104).

4. Method according to one of the claims 1 to 3, comprising at least one of the following features:
at least one of the groove (500) and the contact opening (502), preferably both, is or are formed by a lithography and etching method;
at least one of the groove (500) and the contact opening (502), preferably both, is or are formed by embossing in the carrier structure (102);
at least one of the groove (500) and the contact opening (502), preferably both, is or are formed by laser grooving.

5. Method according to one of the claims 1 to 4, wherein the connection location (108) is formed in a pad-free manner.

6. Method according to one of the claims 1 to 5, wherein the conductor trace (104) and the contact structure (106) comprise a constant cross-section along the entire extension of the conductor trace (104) and the contact structure (106).

7. Method according to one of the claims 1 to 6, wherein the contact structure (106) extends in the carrier structure (102) perpendicularly to an extension of the conductor trace (104) and is formed as a via.

8. Method according to one of the claims 1 to 7,
wherein at least in the region of the connection location (108), the conductor trace (104) and the contact structure (106) are made of a homogenous material.

9. Method according to one of the claims 1 to 8, comprising an electronic component (400) which is embedded in the carrier structure (102) and which is electrically conductively coupled with the contact structure (106) and/or the conductor trace (104), in particular wherein the electronic component (400) comprises a high-frequency component.

10. Method according to claim 9, wherein at another connection location (108), an electric contact (406) of the electronic component (400) on the one hand and the contact structure (106) or the conductor trace (104) on the other hand are merging into each other without a broadening.

11. Method according to one of the claims 1 to 10, comprising another conductor trace (104) in the carrier structure (102), wherein at a further connection location (108), the other conductor trace (104) and the contact structure (106) are merging into each other without a broadening.

12. Method according to one of the preceding claims, further comprising:
providing a driving unit (400) which is configured for coupling a high-frequency signal in the conductor path (110).

13. Method according to claim 12,
wherein the driving unit (400) is configured for coupling a high-frequency signal in a frequency range of at least 10 GHz.

## Revendications

1. Procédé de fabrication d'un dispositif électronique (100), le procédé comprenant les étapes consistant à :
fournir une structure porteuse (102) électriquement isolante, la structure porteuse (102) comprend au moins un choisi dans le groupe constitué par : une plaque contenant une résine, un substrat en verre, un substrat organique ;
former une piste électriquement conductrice (104) sur une surface de la structure porteuse (102) ;
former une structure de contact électriquement conductrice (106) qui s'étend à l'intérieur de la structure porteuse (102) à partir de la surface, et qui est connectée électriquement à la piste conductrice (104) au niveau d'un point de connexion (108) de manière à former un chemin conducteur (110) commun,
une ouverture de contact (502) s'étendant dans la structure porteuse (102) étant formée, qui est ensuite remplie d'un matériau électriquement conducteur, de manière à former la structure de contact (106), de sorte que la structure de contact (106) est réalisée sous la forme d'un trou borgne ou d'un trou traversant rempli du matériau électriquement conducteur dans la structure porteuse (102) ;
la piste conductrice (104) et la structure de contact (106) étant réalisée se fondant l'une dans l'autre sans élargissement au niveau du point de connexion (108),
**caractérisé en ce que**
la piste conductrice (104) et la structure de contact (106) présentent une section transversale constante au moins dans la région du point de connexion (108) ; et
une procédure de définition d'une configuration de la piste conductrice (104) et une procédure de définition d'une configuration de la structure de contact (106) sont consécutives sans interruption ou sont réalisées simultanément.

2. Procédé selon la revendication 1, comprenant :
la piste conductrice (104) et la structure de contact (106) formées selon une procédure commune, en particulier simultanée ou sans interruption.

3. Procédé selon la revendication 1 ou 2, comprenant :
par l'intermédiaire du procédé, la formation d'une rainure (500) sur la surface de la structure porteuse (102) par enlèvement de matière, puis le remplissage du matériau électriquement conducteur pour former ainsi la piste conductrice (104).

4. Procédé selon l'une quelconque des revendications 1 à 3, comprenant au moins l'une des caractéristiques suivantes :
au moins l'une de la rainure (500) et de l'ouverture de contact (502), de préférence les deux, est formée ou sont formées par un procédé de lithographie et de gravure ;
au moins l'une de la rainure (500) et de l'ouverture de contact (502), de préférence les deux, est formée ou sont formées par estampage dans la structure porteuse (102) ;
au moins l'une de la rainure (500) et de l'ouverture de contact (502), de préférence les deux, est formée ou sont formées au moyen d'un rainurage au laser.

5. Procédé selon l'une quelconque des revendications 1 à 4, dans lequel le point de connexion (108) est exempt de pastille.

6. Procédé selon l'une quelconque des revendications 1 à 5, dans lequel la piste conductrice (104) et la structure de contact (106) présentent une section transversale constante le long de toute l'étendue de la piste conductrice (104) et de la structure de contact (106).

7. Procédé selon l'une quelconque des revendications 1 à 6, dans lequel la structure de contact (106) s'étend à l'intérieur de la structure porteuse (102) perpendiculairement à une extension de la piste conductrice (104) et se présente sous la forme d'une traversée.

8. Procédé selon l'une quelconque des revendications 1 à 7,
dans lequel la piste conductrice (104) et la structure de contact (106) sont formées d'un matériau homogène au moins dans la région du point de connexion (108).

9. Procédé selon l'une quelconque des revendications 1 à 8, comprenant un composant électronique (400) qui est incorporé dans la structure porteuse (102) et couplé de manière électriquement conductrice à la structure de contact (106) et/ou à la piste conductrice (104), en particulier dans lequel le composant électronique (400) présente un composant haute fréquence.

10. Procédé selon la revendication 9, dans lequel un contact électrique (406) du composant électronique (400), d'une part, et la structure de contact (106) ou la piste conductrice (104), d'autre part, se fondent l'une dans l'autre sans élargissement au niveau d'un autre point de connexion (108).

11. Procédé selon l'une quelconque des revendications 1 à 10, présentant une autre piste conductrice (104) dans la structure porteuse (102), l'autre piste conductrice (104) et la structure de contact (106) se fondant l'une à l'autre sans élargissement au niveau d'un autre point de connexion (108).

12. Procédé selon l'une quelconque des revendications précédentes, comprenant en outre l'étape consistant à :
fournir un dispositif de commande (400) conçu pour coupler un signal haute fréquence dans le chemin conducteur (110).

13. Procédé selon la revendication 12,
dans lequel le dispositif de commande (400) est conçu pour injecter un signal haute fréquence dans une plage de fréquence d'au moins 10 GHz.
